# FASCICULE DE BREVET EUROPEEN

(11) **EP 4 198 587 B1**
(45) Date de publication et mention de la délivrance du brevet: **06.03.2024**
(21) Numéro de dépôt: 22210320.2
(22) Date de dépôt: 29.11.2022
(51) Int. Cl.: G02B 6/122, G02B 6/13, G02B 6/132, G02B 6/136, G02B 6/12

(54) **PROCÉDÉ DE FABRICATION D'UNE PUCE PHOTONIQUE**
VERFAHREN ZUR HERSTELLUNG EINES PHOTONISCHEN CHIPS
METHOD FOR MANUFACTURING A PHOTONIC CHIP

(30) Priorité: 17.12.2021 FR 2113761
(43) Date de publication de la demande: 21.06.2023
(73) Titulaire: Commissariat à l'énergie atomique et aux énergies alternatives, 75015 Paris (FR)
(72) Inventeur: VIROT, Leopold, 38054 Grenoble cedex 09 (FR); HARTMANN, Jean-Michel, 38054 Grenoble cedex 09 (FR); HASSAN, Karim, 38054 Grenoble Cedex 09 (FR); SZELAG, Bertrand, 38054 Grenoble Cedex 09 (FR); WILMART, Quentin, 38054 Grenoble Cedex 9 (FR)
(74) Mandataire: INNOV-GROUP

(56) Documents cités:
- US-A1- 2015 140 720
- US-A1- 2016 197 111
- US-A1- 2018 231 714

## Description

L'invention concerne un procédé de fabrication d'une puce photonique comportant un premier guide d'onde en nitrure de silicium stoechiométrique, un second guide d'onde en matériau semi-conducteur cristallin et au moins un composant actif optiquement couplé au premier guide d'onde par l'intermédiaire du second guide d'onde. L'invention concerne également la puce photonique fabriquée par ce procédé de fabrication.

Pour certaines applications, il est nécessaire que le guide d'onde en nitrure de silicium présente de très faibles pertes de propagation, en particulier dans la bande C, pour limiter les pertes de propagation optique. La bande C est la bande des longueurs d'onde qui va de 1530 nm à 1565 nm.

La fabrication de tels guides d'onde en nitrure de silicium nécessite la mise en oeuvre de traitements thermiques à température élevée, c'est-à-dire des températures dépassant 1000°C ou 1200°C. Ces traitements thermiques ne sont pas compatibles avec la fabrication dans la même puce photonique de composants actifs tels que des photo-détecteurs, des modulateurs ou des sources lasers.

Actuellement, pour contourner cette difficulté, le guide d'onde en nitrure de silicium est fabriqué sur un substrat et les composants actifs sont fabriqués séparément sur un autre substrat. Ensuite, les deux substrats sont assemblés, par exemple par collage, pour obtenir la puce photonique comportant à la fois des composants actifs et un guide d'onde en nitrure de silicium présentant de très faibles pertes de propagation. Un exemple d'un tel procédé de fabrication est divulgué dans US2018/231714A1. Ces procédés connus de fabrication sont complexes.

De l'état de la technique est également connu de US2015/140720A1 et US2016/197111A1.

L'invention vise à proposer un procédé de fabrication de ces puces photoniques plus simple. Elle a donc pour objet un procédé de fabrication conforme à la revendication 1.

Elle a également pour objet une puce photonique conforme à la revendication 12, la puce photonique fabriquée par le procédé de fabrication conforme à la revendication 1.

L'invention sera mieux comprise à la lecture de la description qui va suivre, donnée uniquement à titre d'exemple non limitatif et faite en se référant aux dessins sur lesquels :
- la figure 1 est une illustration schématique, en coupe verticale, d'une puce photonique selon l'invention revendiquée.
- la figure 2 est un organigramme d'un premier procédé de fabrication de la puce photonique de la figure 1 ;
- les figures 3 à 15 sont des illustrations schématiques de différents états de fabrication rencontrés lors de la mise en oeuvre du procédé de fabrication de la figure 2 ;
- la figure 16 est un organigramme d'un deuxième procédé de fabrication de la puce photonique de la figure 1 ;
- les figures 17 à 23 sont des illustrations schématiques de différents états de fabrication rencontrés lors de la mise en oeuvre du procédé de la figure 16 ;
- les figures 24 à 28 sont des illustrations schématiques, en coupe verticale, illustrant chacune un état de fabrication rencontré lors de la mise en oeuvre de variantes respectives des procédés de fabrication des figures 2 et 16 ;
- la figure 29 est une illustration schématique, en coupe verticale, d'un état de fabrication d'une puce photonique fabriquée en combinant deux des procédés de fabrication décrits en référence aux figures précédentes ;
- la figure 30 est une illustration schématique, en coupe verticale, d'un autre état de fabrication rencontré lors de la fabrication d'une variante de la puce photonique de la figure 1.

Dans ces figures, les mêmes références sont utilisées pour désigner les mêmes éléments. Dans la suite de cette description, les caractéristiques et fonctions bien connues de l'homme du métier ne sont pas décrites en détail.

Par la suite, les définitions de certains termes et expressions utilisées dans cette demande sont données dans un chapitre I. Ensuite, des exemples détaillés de modes de réalisation sont décrits dans un chapitre II en référence aux figures. Dans le chapitre III suivant, des variantes de ces modes de réalisation sont présentées. Enfin, les avantages des différents modes de réalisation sont présentés dans un chapitre IV.

### CHAPITRE I : Terminologie et définitions

Dans ce texte, lorsque l'on indique qu'un guide d'onde est réalisé en matériau X, cela signifie que le coeur de ce guide d'onde est réalisé dans ce matériau X. La gaine de ce guide d'onde est réalisée dans un autre matériau d'indice de réfraction plus faible.

Lorsqu'on indique qu'un élément "est réalisé en matériau X", cela signifie que le matériau X représente plus de 90% ou 95% ou 98% de la masse de cet élément.

L'expression "réaliser un guide d'onde dans une couche de matériau X" désigne le fait de réaliser le coeur de ce guide d'onde dans cette couche de matériau X. La gaine de ce guide d'onde est réalisée dans un autre matériau dont l'indice de réfraction est plus faible que celui de cette couche en matériau X.

Lorsqu'il est indiqué qu'un guide d'onde se situe entre des plans inférieur et supérieur, cela signifie que c'est le coeur de ce guide d'onde qui est situé entre ces plans inférieur et supérieur.

Ici, des paramètres de maille d'un matériau cristallin A sont considérés comme "similaires" aux paramètres de maille d'un matériau cristallin B si, pour chaque paramètre de maille du matériau cristallin A, l'écart entre ce paramètre de maille et le paramètre de maille correspondant du matériau cristallin B, est inférieur à 5% de la valeur de ce paramètre de maille pour le matériau cristallin A.

Un couplage "évanescent" entre deux guides d'onde est un couplage qui permet de transférer une fraction du signal optique qui se propage dans l'un des guides d'onde vers l'autre. Typiquement, un couplage évanescent permet de transférer au moins 50% de l'énergie du signal optique qui se propage dans l'un des guides d'onde vers l'autre guide d'onde. Les couplages évanescents sont bien connus. Par exemple, ils sont définis dans le livre suivant R. G. Hunsperger : "Intergrated Optics : Theory and Technology", Springer, 2002, page 154-155. Pour réaliser un couplage évanescent entre deux guides d'onde, il faut conformer ces guides d'ondes pour :
- que chacun d'eux présente une portion en vis-à-vis de l'autre guide d'onde, et
- que les indices effectifs de ces portions en vis-à-vis soient égaux.

L'indice effectif n_{eff} de propagation est aussi connu sous le nom de « constante de phase du mode ». Il est défini par la relation suivante : n_{g} = n_{eff} - λdn_{eff}/dλ, où n_{g} est l'indice de groupe et λ est la longueur d'onde du signal optique guidé par le guide. L'indice effectif de propagation d'un guide d'onde dépend des dimensions du coeur de ce guide d'onde et des matériaux formant ce coeur et la gaine de ce guide d'onde. Il peut être déterminé expérimentalement ou par simulation numérique.

La gaine d'un guide d'onde est généralement réalisée en matériau diélectrique. Dans ce cas le matériau diélectrique est un matériau diélectrique dont l'indice n_{g} de réfraction est plus petit que l'indice n_{c} de réfraction du coeur du guide d'onde. Typiquement, l'indice n_{g} est inférieur ou égal à 0,85*n_{c} ou inférieur ou égal à 0,75*n_{c}.

Dans ce texte, le symbole "*" désigne l'opération de multiplication arithmétique.

La largeur d'un élément désigne ici la largeur de cet élément mesurée dans une direction horizontale perpendiculaire à la direction de propagation du signal optique dans cet élément.

Une section transversale d'un élément est une section perpendiculaire à la direction de propagation du signal optique dans cet élément.

L'expression "très faible perte de propagation" désigne un guide d'onde dans lequel les pertes de propagation, à la longueur d'onde des signaux optiques utiles qui se propagent dans ce guide d'onde, sont inférieures à 4 dB/m et, de préférence, inférieures à 3 dB/m ou 2 dB/m. Dans ce texte, sauf indication contraire, un guide d'onde qui présente de très faibles pertes de propagation désigne un guide d'onde pour lequel les pertes de propagation dans la bande C sont inférieures à 4 dB/m et, de préférence, inférieures à 3 dB/m ou 2 dB/m.

La bande C est la bande de longueurs d'onde qui va de 1530 nm à 1565 nm.

### CHAPITRE II : Exemples de modes de réalisation

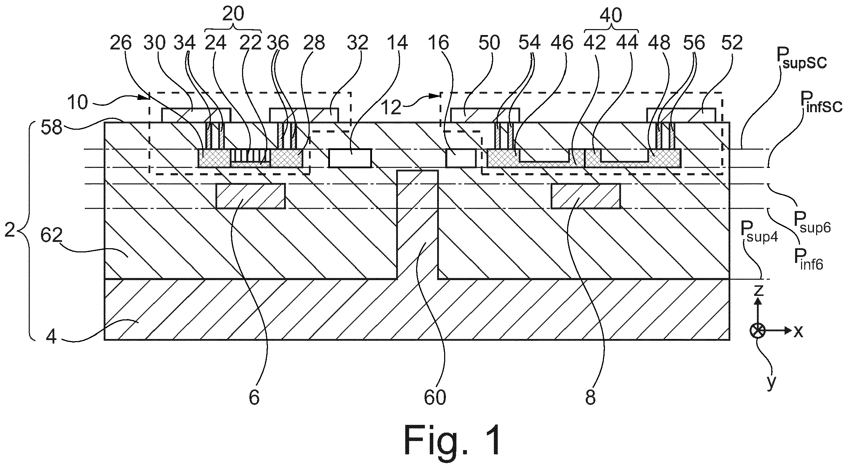

La figure 1 représente une puce photonique 2 comportant successivement déposés les uns au-dessus des autres dans une direction verticale :
- un substrat 4 en silicium monocristallin,
- deux guides d'onde 6 et 8 en nitrure de silicium, et
- deux composants photoniques actifs 10 et 12.

La direction verticale sur la figure 1 et les figures suivantes est représentée par une direction Z d'un repère orthogonal XYZ. Les directions X et Y sont des directions horizontales. Par la suite, les termes tels que *« supérieur », « inférieur »,* « *au-dessus* », *« au-dessous* » et similaires sont définis par rapport à la direction Z.

Le substrat 4 s'étend principalement dans un plan horizontal appelé plan du substrat. L'épaisseur du substrat 4 est typiquement supérieure à 5 µm ou 10 µm ou plus. La face supérieure du substrat 4 s'étend dans un plan horizontal Pₛᵤₚ₄.

Les guides 6 et 8 s'étendent verticalement chacun depuis un même plan inférieur P_{inf6} jusqu'à un même plan supérieur Pₛᵤₚ₆. Les plans P_{inf6} et Pₛᵤₚ₆ sont horizontaux. Le plan P_{inf6} est séparé du plan Pₛᵤₚ₄ par une distance verticale supérieure à 1 µm ou 2 µm. Le plan Pₛᵤₚ₆ est séparé du plan P_{inf6} par une distance verticale supérieure à 200 nm et, généralement, inférieure à 900 nm ou à 700 nm ou à 500 nm ou à 350 nm. Cette distance verticale correspond à l'épaisseur e₆ des guides 6 et 8. La distance verticale entre les plans Pₛᵤₚ₆ et Pₛᵤₚ₄ est supérieure à 1 µm et, généralement, supérieure à 3 µm ou 4 µm.

Les guides 6 et 8 sont utilisés pour guider un signal optique à une longueur d'onde λ_{SO}. Typiquement, la longueur d'onde λ_{SO} est comprise entre 1 000 nm et 2 000 nm. Ici, à titre d'illustration, la longueur d'onde λ_{SO} est comprise dans la bande C. Sur la figure 1, les guides 6 et 8 sont représentés dans le cas particulier où la direction de propagation du signal optique dans ces guides est parallèle à la direction Y. Ainsi, seule la section transversale des guides 6 et 8 est visible sur la figure 1. La longueur des guides 6 et 8 est plusieurs fois supérieure à leur largeur.

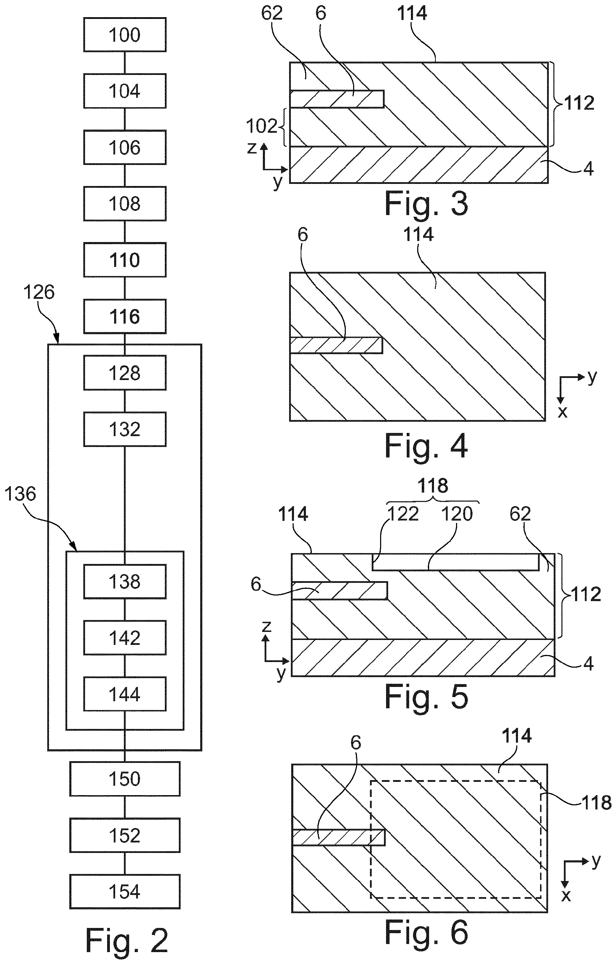

Pour limiter les pertes de propagation du signal optique, les guides 6 et 8 sont réalisés en nitrure de silicium stoechiométrique à très faibles pertes de propagation. La composition du nitrure de silicium stoechiométrique est définie par la formule suivante : Si₃N₄. Pour obtenir de très faibles pertes de propagation dans la bande C, les guides 6 et 8 sont réalisés dans du nitrure de silicium stoechiométrique déposé par un procédé de dépôt chimique en phase vapeur suivi d'un recuit. Ce procédé de fabrication des guides 6 et 8 est décrit plus en détail en référence à la figure 2.

Les composants actifs 10 et 12 sont des composants optiques qui, lorsqu'ils sont alimentés :
- modifient l'amplitude ou la phase du signal optique qui les traverse ou génèrent un signal optique, ou
- mesurent l'amplitude ou la phase du signal optique qui les traverse.

Par exemple, les composants 10 et 12 sont choisis dans le groupe constitué :
- d'un modulateur de l'amplitude et/ou de la phase du signal optique,
- d'un photo-détecteur qui mesure l'amplitude du signal optique, et
- d'une source laser qui génère un signal optique.

Ces différents composants actifs ont en commun qu'ils comportent chacun des prises de contact électrique utilisées pour les alimenter électriquement et/ou pour relever le signal électrique qu'ils génèrent lorsqu'ils sont traversés par un signal optique.

Chacun de ces composants actifs comporte une partie active qui est traversée par le signal optique. Les parties actives des composants actifs sont réalisées dans des portions, respectivement, de guides d'onde 14 et 16. Les guides d'onde 14 et 16 sont des guides d'onde en matériau semi-conducteur cristallin.

Sur la figure 1, la section transversale des guides 14 et 16 est représentée à côté des composants 10 et 12. Toutefois, en réalité, les guides 14 et 16 se situent dans le prolongement, dans la direction Y, des parties actives des composants 10 et 12. Ainsi, en réalité, les guides 14 et 16 sont situés devant ou derrière les parties actives représentées.

Les guides 14 et 16 sont les guides dans lesquels sont réalisées les parties actives, respectivement, des composants 10 et 12. Les guides 14 et 16 sont directement optiquement couplés, par des couplages évanescents, respectivement, aux guides 6 et 8.

Dans ce mode de réalisation, les guides 14 et 16 sont réalisés dans le même matériau semi-conducteur cristallin que celui du substrat 4, c'est-à-dire en silicium monocristallin. Ces guides 14 et 16 sont décrits plus en détail lors de la description de leur procédé de fabrication.

Les coeurs des guides 14 et 16 s'étendent chacun depuis un plan inférieur horizontal P_{infSC} jusqu'à un plan supérieur horizontal P_{supSC}. Le plan P_{infSC} est séparé du plan Pₛᵤₚ₆ par une distance verticale supérieure à 10 nm ou 30 nm et, généralement, inférieure à 150 nm ou à 100 nm. Le plan P_{supSC} est séparé du plan P_{infSC} par une distance verticale supérieure à 200 nm et, généralement, inférieure à 700 nm ou à 500 nm. L'épaisseur esc des guides 14 et 16 est égale à la distance verticale entre les plans P_{infSC} et P_{supSC}. Ici, l'épaisseur e_{SC} est égale à l'épaisseur e₆ des guides 6 et 8. Ainsi, dans la zone où ces guides 14 et 16 doivent être couplés, par couplage évanescent, respectivement aux guides 6 et 8, les largeurs des portions en vis-à-vis des guides en silicium monocristallin et en nitrure de silicium sont ajustées pour que ces portions en vis-à-vis présentent les mêmes indices effectifs de propagation.

La figure 1 est représentée dans le cas particulier où les signaux optiques se propagent dans les composants actifs parallèlement à la direction Y. Ainsi, seule la section transversale de ces composants 10 et 12 est visible. Typiquement, les parties actives de ces composants 10 et 12 s'étendent chacune depuis le plan P_{infSC} jusqu'au plan P_{supSC}.

À titre d'illustration :
- le composant 10 est une photodiode qui mesure l'intensité du signal optique qui la traverse, et
- le composant 12 est un modulateur qui modifie l'amplitude et la phase du signal optique qui le traverse.

Ainsi, le composant 10 comporte un guide d'onde 20. Le guide 20 s'étend principalement dans la direction Y. Il est réalisé dans une portion du guide 14 et optiquement couplé au reste du guide 14, typiquement, par un couplage d'extrémité dans lequel une extrémité d'une portion du guide 14 vient en butée sur une extrémité du guide 20. Un tel couplage est connu sous le terme anglais de « *Butt coupling ».*

Ici, le guide 20 comporte une semelle inférieure 22 et un corps 24 en germanium. La semelle 22 s'étend depuis le plan P_{infSC} vers le plan P_{supSC}. L'épaisseur e₂₂ de la semelle 22 est inférieure ou égale à 30 % ou 10 % de l'épaisseur esc. La semelle 22 s'étend dans le prolongement du guide 14. Typiquement, elle ne forme qu'un seul bloc de matière avec le guide 14. Ici, le corps 24 s'étend depuis la face supérieure de la semelle 22 jusqu'au plan P_{supSC}.

À droite et à gauche du guide 20, dans la direction X, le composant 10 comporte deux régions dopées, respectivement, 26 et 28. La région 26 présente un dopage de signe opposé à la région 28. Les régions 26 et 28 touchent et longent les flancs verticaux du guide 20.

Le composant 10 comporte aussi deux prises 30, 32 de contact électrique pour raccorder le composant 10 à un appareil d'acquisition des mesures de ce composant 10. La prise 30 est électriquement raccordée à la région 26 par des via métalliques verticaux 34. La prise 32 est électriquement raccordée à la région 28 par des via métalliques 36.

Le composant 12 comporte un guide d'onde 40 qui s'étend principalement dans la direction Y. Le guide 40 est réalisée dans une portion du guide 16. Le guide 40 est optiquement couplé au reste du guide 16 par un couplage d'extrémité similaire à celui utilisé pour coupler le guide 14 au guide 20.

Ici, le guide 40 comporte deux régions 42 et 44 de dopage opposé directement en contact l'une avec l'autre le long d'une interface verticale pour former une diode à jonction PN. Ici, les régions 42 et 44 sont obtenues par dopage de deux régions d'une portion du guide 16.

De plus, chaque région 42 et 44 se prolongent latéralement, parallèlement à la direction X, pour former, respectivement, des ailes 46 et 48 de contact électrique.

Le composant 12 comporte aussi deux prises 50, 52 de contact électrique. Les prises 50 et 52 sont électriquement raccordées, respectivement, aux ailes 46 et 48 par des via métalliques verticaux, respectivement, 54 et 56.

Les prises 30, 32, 50 et 52 sont formées sur une face extérieure 58 de la puce photonique 2. La face extérieure 58 s'étend parallèlement au plan Pₛᵤₚ₄ et est située à plus de 500 nm et, typiquement, à plus de 1 µm ou 2 µm au-dessus du plan P_{supSC}.

La puce photonique 2 comporte aussi au moins un plot 60 qui s'étend verticalement depuis le plan Pₛᵤₚ₄ jusqu'au plan P_{infSC}. Le plot 60 est un reliquat du procédé de fabrication mis en oeuvre pour fabriquer, notamment, les guides 14 et 16. Le plot 60 ne remplit aucune fonction et sa présence ne modifie en rien le fonctionnement des différents éléments de la puce photonique 2.

Ce plot 60 correspond à une ouverture qui, lors du procédé de fabrication de la puce photonique 2, est remplie d'un matériau, appelé par la suite "matériau de germination cristalline" car il est utilisé pour former un germe cristallin au niveau du plan P_{infSC}.

Le matériau de germination cristalline est un matériau cristallin dont les paramètres de maille sont similaires à ceux du matériau semi-conducteur cristallin dans lequel sont réalisés les guides 14 et 16. Dans ce premier mode de réalisation, le matériau de germination cristalline est du silicium monocristallin.

Ce plot 60 est suffisamment éloigné des guides 6, 8, 14 et 16 et des composants 10 et 12 pour que l'indice effectif de propagation de ces éléments ne soit pas modifié par la présence du plot 60. Par exemple, à cet effet, le plot 60 est séparé de chacun de ces éléments par une distance horizontale supérieure à 0,6λ_{SO} ou supérieure à 0,8λ_{SO} ou supérieure à λ_{SO}. Ici, cette distance de séparation est supérieure à 1 µm ou 1,5 µm.

Les coeurs des guides d'onde précédemment décrits et des parties actives des composants 10 et 12 sont encapsulés dans un matériau diélectrique 62. Le matériau 62 forme ici les gaines des guides 6, 8, 14, 16, 20 et 40. Par exemple, le matériau 62 est de l'oxyde de silicium (SiO₂).

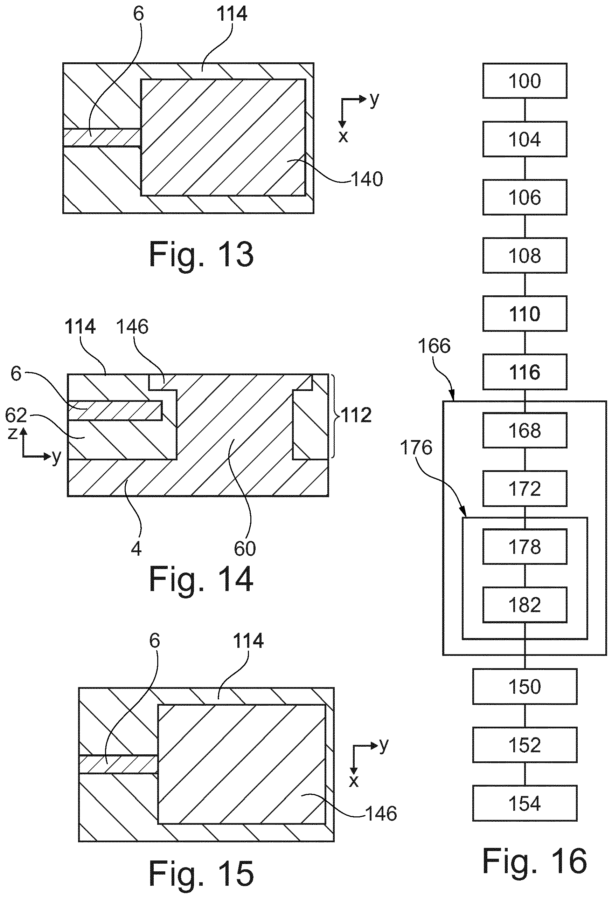

Un premier procédé de fabrication de la puce 2 va maintenant être décrit en référence à l'organigramme de la figure 2 et à l'aide des figures 13 à 15. Les figures 3, 5, 7, 9, 11, 12 et 14 sont des vues en coupe verticale parallèles aux directions Y et Z et passant par le guide 16. Les figures 4, 6, 8, 10, 13 et 15 sont des vues de dessus. Dans ces vues de dessus, le guide 6 est visible par transparence à travers le matériau 62.

Par la suite, seule la fabrication des guides 6 et 14 et du composant 10 est décrite. L'enseignement donné dans ce cas particulier se transpose sans difficulté à la fabrication des guides 8 et 16 et du composant 12. Typiquement, les guides 6 et 8 et les guides 14 et 16 sont fabriqués en parallèle sur le même substrat 4.

Le procédé débute par une étape 100 de fourniture d'un empilement comportant le substrat 4 et une couche 102 (figure 3) du matériau 62. La couche 102 recouvre la face supérieure du substrat 4.

Lors d'une étape 104, une couche de nitrure de silicium stoechiométrique est déposée sur la face supérieure de la couche 102. À cet effet, cette couche est déposée selon un procédé de dépôt chimique en phase vapeur sous faible pression. Le dépôt chimique en phase vapeur est connu sous l'acronyme CVD (« *Chemical Vapor Deposition* »). Le dépôt chimique en phase vapeur sous faible pression est connu sous l'acronyme LPCVD (« *Low Pressure Chemical Vapor Deposition* »).Typiquement, lors de la mise en oeuvre de ce procédé de dépôt en phase vapeur, la pression du gaz est inférieure à 39996 mPa (300 mTorr) et, de préférence, inférieure à 19998 mPA (150 mTorr). Ce procédé de dépôt permet de déposer du nitrure de silicium stœchiométrique.

Ensuite, lors d'une étape 106 de recuit, la couche en nitrure de silicium stoechiométrique déposée est chauffée pour que ses pertes de propagation deviennent très faibles. Pour cela, typiquement, la couche de nitrure de silicium stoechiométrique est chauffée à une température comprise entre 1000 °C et 1400 °C, et de préférence, entre 1100°C et 1300°C, pendant une durée suffisante pour obtenir les très faibles pertes de propagation souhaitées. Par exemple, la durée du recuit est comprise entre 1 heure et 3 heures.

Ensuite, lors d'une étape 108, le guide 6 est réalisé dans la couche en nitrure de silicium stoechiométrique déposée. Pour cela, la couche est gravée afin d'obtenir la largeur souhaitée pour le guide 6.

Lors d'une étape 110, le guide 6 réalisé sur la face supérieure de la couche 102 est encapsulé dans le matériau 62 pour obtenir une couche 112 (figure 3) d'encapsulation à l'intérieur de laquelle le guide 6 est enfoui. À ce stade, l'état de fabrication représenté sur les figures 3 et 4 est obtenu. La couche 112 présente une face supérieure 114 (figures 3 et 4) plane et horizontale à ce stade. Le guide 6 est situé entre les plans P_{inf6} et Pₛᵤₚ₆.

Ensuite, lors d'une étape 116 (figures 5 et 6), la face supérieure 114 est structurée pour y former un logement creux 118 à l'intérieur duquel sera formée une couche en matériau semi-conducteur cristallin.

Le logement 118 est réalisé à l'emplacement où doit être réalisé le guide 14 et la partie active du composant 10. Ici, le guide 14 comporte une portion qui se situe au-dessus et en vis-à-vis d'une portion correspondante du guide 6 afin d'obtenir un couplage évanescent direct entre ces deux guides. Ainsi, le logement 118 s'étend lui aussi en partie au-dessus du guide 6.

Ce logement 118 comporte un fond horizontal 120 entouré de parois verticales 122. La profondeur du logement 118 est égale à l'épaisseur esc du guide 14 à réaliser. Le fond 120 est donc contenu dans le plan P_{infSC}. Les dimensions horizontales du logement 118 sont suffisantes pour pouvoir réaliser le guide 14 et la partie active du composant 10. En particulier, la largeur du logement 118 dans la direction X est suffisamment grande afin de pouvoir espacer le guide 14 et la partie active du composant 10 du plot 60 comme décrit en regard de la figure 1.

Lors d'une étape 126, une couche en matériau semi-conducteur cristallin identique à celui du guide 14 est créée sur la face supérieure 114. Ici, cette couche en matériau semi-conducteur cristallin est donc réalisée en silicium monocristallin.

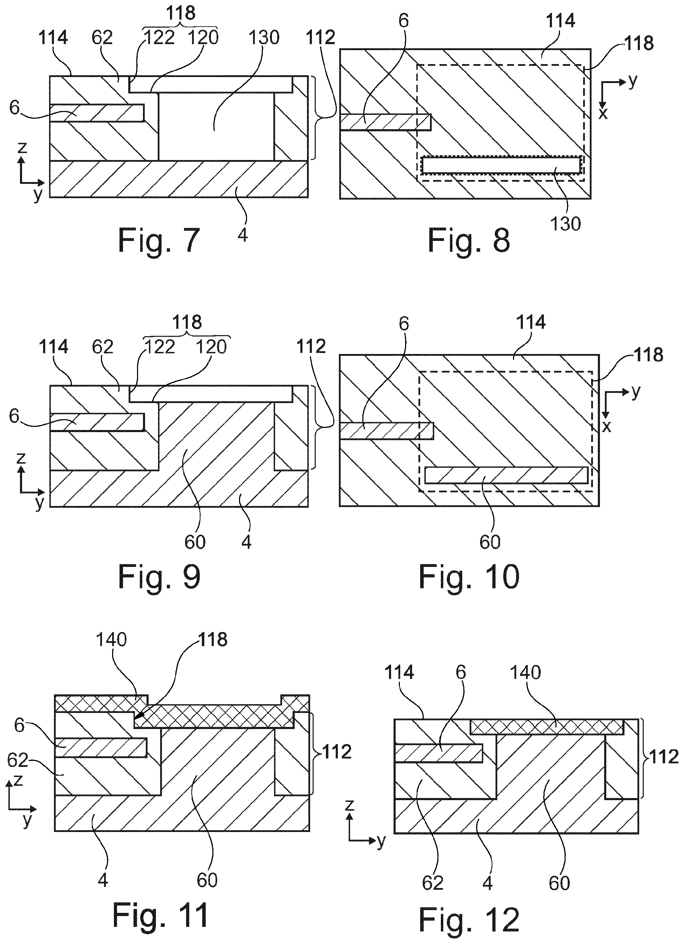

Pour cela, lors d'une opération 128 (figures 7 et 8), une seule ouverture 130 est formée à l'emplacement du plot 60 dans le fond 122. Cette ouverture 130 débouche ici, d'un côté, directement sur la face supérieure du substrat 4 et, du côté opposé, dans le fond 120. L'ouverture 130 s'étend donc verticalement depuis le plan Pₛᵤₚ₄ jusqu'au plan P_{infSC}. Ici, cette ouverture 130 est une tranchée. Une tranchée est une ouverture dont la longueur de la section horizontale est au moins deux fois supérieure à sa largeur. La longueur Lo₁₃₀ de l'ouverture 130 s'étend essentiellement parallèlement au guide 14 à réaliser. La longueur de cette ouverture 130 s'étend donc ici parallèlement à la direction Y. La longueur Lo₁₃₀ est proche de la longueur Lo₁₁₈ du logement 118 dans la direction Y. Par exemple, la longueur Lo₁₃₀ est supérieure ou égale à 0,8*Lo₁₁₈ ou à 0,9*Lo₁₁₈. La longueur Lo₁₃₀ est inférieure à longueur Lo₁₁₈.

La largeur La₁₃₀ de l'ouverture 130 est deux fois plus petite que sa longueur Lo₁₃₀. Ici, la largeur La₁₃₀ est choisie supérieure à a₁₃₀*h_{infSC}, où :
- h_{infSC} est égale à la distance verticale entre le plan Pₛᵤₚ₄ et le plan P_{infSC}, et
- a₁₃₀ est un rapport de forme souhaité qui permet de remplir complètement l'ouverture 130 avec le matériau de germination cristalline choisi.

Typiquement, le rapport a₁₃₀ est supérieur à 1/10 ou 1/4 et inférieur à 3/4 ou à 1/2. De préférence, le rapport a₁₃₀ est choisi aussi petit que possible pour limiter l'encombrement du plot 60.

Lors d'une opération 132 (figures 9 et 10), le matériau de germination cristalline est déposé à l'intérieur de l'ouverture 130. Ici, le matériau de germination cristalline est du silicium monocristallin. Il est déposé par croissance épitaxiale à partir du substrat 4, c'est-à-dire à partir du fond de l'ouverture 130. Il s'agit d'une épitaxie localisée et sélective de silicium monocristallin. Une telle épitaxie est connue sous l'acronyme SEG (*« Selective Epitaxy Growth* »). Cette croissance épitaxiale est par exemple réalisée en phase vapeur. La croissance épitaxiale est arrêtée lorsque le silicium monocristallin déposé dans l'ouverture 130 affleure le fond 120 ou forme une saillie sur ce fond 120.

Lors de l'opération 132, le silicium monocristallin doit croître sur une hauteur h_{infSC} importante tout en conservant les mêmes paramètres de maille que ceux du substrat 4 pour former un germe cristallin aussi pur que possible sur le fond 120. Un germe cristallin est d'autant plus pur qu'il présente moins de défaut de cristallisation. En particulier, l'apparition de silicium polycristallin dans le germe cristallin doit être évitée. Pour respecter cette contrainte, de l'acide chlorhydrique (HCl) est ajouté dans le mélange gazeux utilisé pour faire croître le silicium monocristallin à l'intérieur de l'ouverture 130. Par exemple, le procédé décrit dans l'article suivant est mis en oeuvre sauf que la croissance du silicium monocristallin est arrêtée dès que le silicium monocristallin affleure le fond 120 et sans chercher à obtenir une croissance latérale du silicium monocristallin à l'intérieur du logement 118 : D. D. Rathman, D. J. Silversmith, et J. A. Burns : « Lateral Epitaxial Overgrowth of Silicon on SiO2 », J. Electrochem. Soc., vol. 129, n° 10, p. 2303-2306, oct. 1982, doi: 10.1149/1.2123499.

À ce stade, le plot 60 est obtenu et l'extrémité supérieure du plot 60 forme un germe cristallin en silicium monocristallin sur la face supérieure de la couche 112 et plus précisément, ici, sur le fond 120.

De préférence, à la fin de l'opération 132, toute trace d'oxyde est nettoyée sur le germe cristallin obtenu. Par exemple pour cela, un nettoyage à l'acide fluorhydrique est réalisé.

Lors d'une opération 136, une épitaxie latérale, à partir du germe cristallin réalisé sur le fond 120 est exécuté. Cette épitaxie latérale permet de remplir complètement le logement 118 de matériau semi-conducteur cristallin. Dans ce mode de réalisation, à cet effet, une épitaxie latérale en phase solide est réalisée. Pour cela, lors d'une sous-opération 138 (figure 11), une couche 140 de silicium amorphe est déposée sur toute la face supérieure 114 de la couche 112. Par exemple, le silicium amorphe est déposé en mettant en oeuvre un procédé chimique de dépôt en phase vapeur. La couche 140 remplit complètement le logement 118. À cet effet, son épaisseur est supérieure ou égale à l'épaisseur esc. La couche 140 déborde ici à l'extérieur du logement 118 et recouvre la totalité de la face supérieure 114.

Ensuite, lors d'une sous-opération 142 (figures 12 et 13), les portions de la couche 140 située à l'extérieur du logement 118 sont éliminées. Par exemple, pour cela, un polissage mécano-chimique est exécuté. Ce polissage est plus connu sous l'acronyme CMP (« *Chemical-Mechanical Polishing »*)*.* Ce polissage est arrêté quand la face supérieure 114 à l'extérieur du logement 118 est mise à nue. L'état de fabrication représenté sur les figures 12 et 13 est alors obtenu. À ce stade, le logement 118 est complètement rempli de silicium amorphe et l'épaisseur de ce silicium amorphe est égale à la profondeur du logement 118, c'est-à-dire égale à l'épaisseur esc.

Ensuite, lors d'une sous-opération 144 (figures 14 et 15), la couche 140 est soumise à un recuit à une température qui provoque la cristallisation à partir du germe cristallin formé sur le fond 120. Ici, cette température de cristallisation est inférieure à la température de fusion du silicium monocristallin. Dans ce cas, l'épitaxie réalisée est dite « *en phase solide* » car lors de la cristallisation de la couche 140, celle-ci reste à l'état solide. Par exemple, dans le cas de la couche 140 en silicium amorphe, la température du recuit est égale à 700°C. La durée du recuit nécessaire pour provoquer la cristallisation de la couche 140 est généralement compris entre 1 s et 10 s. À l'issue de la sous-opération 144, la couche 140 s'est transformée en une couche 146 en silicium monocristallin. L'opération 136 et l'étape 126 sont alors terminées.

Ensuite, lors d'une étape 150, le guide 14 et la partie active du composant 10 sont réalisés dans la couche 146 créée lors de l'étape 126. Le guide 14 et la partie active du composant 10 sont réalisés à un emplacement aussi éloigné que possible du plot 60. Par exemple, pour cela, le guide 14, la semelle 22 et les régions 26 et 28 en silicium sont obtenus par gravure de la couche 146. Ensuite, les différentes opérations pour réaliser la partie active du composant 10 sont exécutées. Classiquement, ces opérations comportent le dépôt et la formation du corps 24 en germanium sur la semelle 22 et le dopage des régions 26 et 28.

Lorsque la réalisation du guide 14 et de la partie active du composant 10 est terminée, lors d'une étape 152, le guide 14 et cette partie active sont encapsulés dans un matériau diélectrique. Ici, le matériau diélectrique est de l'oxyde de silicium. Pour cela, typiquement, une couche d'oxyde de silicium est déposée sur la face supérieure 114 puis cette couche déposée est polie pour former la face extérieure 58 de la puce 2.

Lors d'une étape 154, les via métalliques 34 et 36 sont formés puis les prises 30 et 32 sont réalisées sur la face extérieure 58.

La fabrication de la puce 2 est alors terminée.

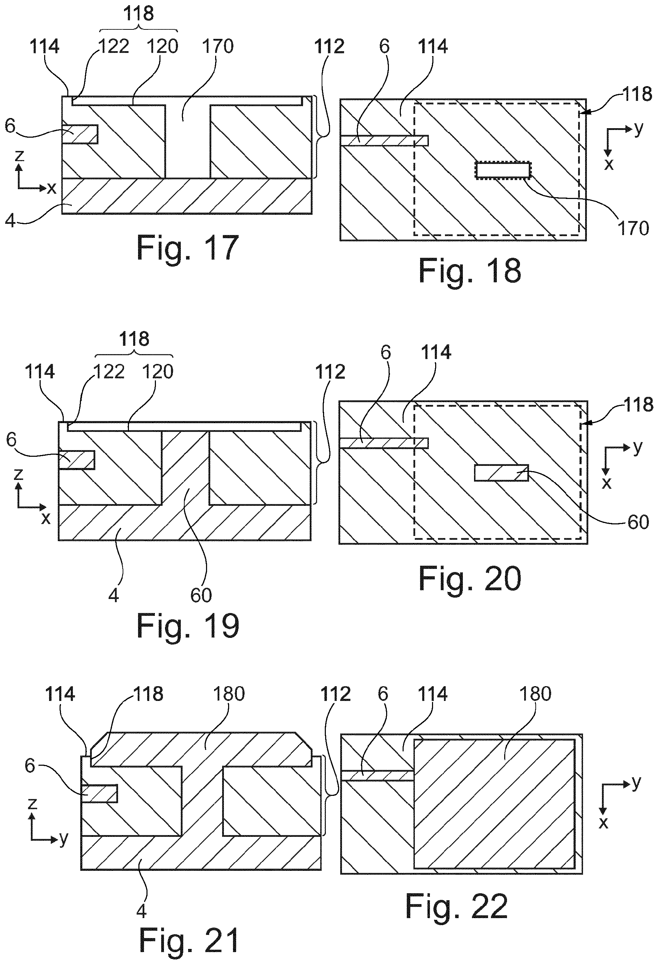

Un deuxième procédé de fabrication est maintenant décrit à l'aide de l'organigramme de la figure 16 et des figures 17 à 23. Les figures 17, 19, 21 et 23 sont des vues en coupe verticale, parallèles aux directions Y et Z, passant par le guide 6. Les figures 18, 20 et 22 sont des vues de dessus. Dans ces vues de dessus, le guide 6 est visible par transparence à travers le matériau 62.

Ce deuxième procédé de fabrication est identique au premier procédé de fabrication sauf que l'étape 126 de création de la couche en matériau semi-conducteur cristallin est remplacée par une étape 166 de création de cette couche en matériau semi-conducteur cristallin.

L'étape 166 débute par une opération 168 (figures 17 et 18) de formation d'une ouverture 170. Cette opération 168 est identique à l'étape 128 sauf que l'ouverture 170 est réalisée au centre du fond 120 de sorte que les distances qui séparent, dans les directions X et Y, les parois verticales 122 du logement 118 du bord le plus proche de cette ouverture 170 sont toutes égales. Ici, étant donné que la section horizontale du logement 118 est rectangulaire, la section horizontale de l'ouverture 170 est aussi rectangulaire. Dans ce mode de réalisation, la section horizontale de l'ouverture 170 se déduit par homothétie de la section horizontale du logement 118. De préférence, le facteur k de cette homothétie est inférieur à 0,7 ou 0,5.

Ensuite, lors d'une opération 172 (figures 19 et 20), le matériau de germination cristalline est déposé à l'intérieur de l'ouverture 170. Cette opération 172 est par exemple identique à l'opération 132.

Lors d'une opération 176 (figures 21 et 22), une épitaxie latérale, à partir du germe cristallin réalisé sur le fond 120, est exécutée. Ici, il s'agit d'une épitaxie latérale en phase vapeur. Pour cela, lors d'une sous-opération 178, une couche 180 en silicium monocristallin est directement déposée à l'intérieur du logement 118 jusqu'à remplir complètement l'intérieur de ce logement 118.

À cet effet, la croissance latérale du silicium monocristallin est privilégiée à sa croissance verticale. La croissance latérale correspond ici à une croissance horizontale du silicium monocristallin. Un tel procédé est connu sous l'acronyme ELOG (« *Epitaxial Lateral Over-Growth »*)*.* Par exemple, par rapport à la croissance épitaxiale mise en oeuvre pour remplir l'ouverture 170, la croissance latérale est privilégiée en changeant la composition chimique du gaz à partir duquel le silicium monocristallin est déposé et/ou la température de ce gaz et/ou la pression de ce gaz. Par exemple, le procédé de croissance latérale du silicium décrit dans l'article de D. D Rathman, précédemment cité, convient.

La croissance latérale est interrompue seulement après que la totalité du logement 118 ait été remplie de silicium monocristallin. À ce stade, l'épaisseur de la couche 180 est supérieure à la profondeur du logement 118. Ainsi, la couche 180 comporte une surépaisseur en saillie au-dessus de la face supérieure 114.

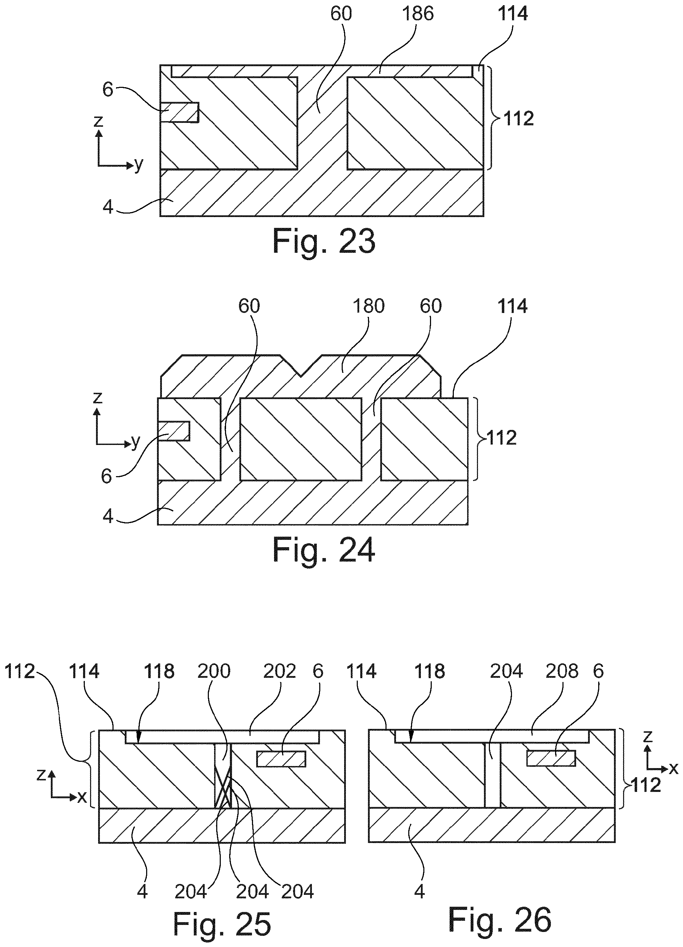

Lors d'une sous-opération 182 (figure 23), la surépaisseur de la couche 180 qui dépasse au-dessus de la face supérieure 114 est éliminée, par exemple, par polissage mécano-chimique. Cette sous-opération 182 est par exemple identique à la sous-opération 142.

Une fois cette surépaisseur éliminée, l'état de fabrication représenté sur la figure 23 est obtenu. Plus précisément, à l'issue de l'étape 176, une couche 186 en silicium monocristallin a été créée. Cette couche est par exemple identique à la couche 146. À ce stade, l'opération 176 et l'étape 166 sont terminées.

La suite des étapes du deuxième procédé est identique à celles décrites dans le cas du premier procédé de fabrication.

Un troisième procédé de fabrication est illustré à l'aide de la figure 24. Le troisième procédé de fabrication est identique au deuxième procédé de fabrication sauf que lors de l'opération 168, plusieurs ouvertures 170 régulièrement espacées les unes des autres sont formées dans le fond 120 du logement 118.

Dans ce cas, l'étape 172 conduit à former plusieurs germes cristallins sur le fond 120. Ensuite, lors de la sous-opération 178, le silicium monocristallin croît latéralement à partir de chacun de ces germes cristallins. La croissance latérale est poursuivie jusqu'à ce que les différents blocs de silicium monocristallin qui croissent chacun à partir d'un germe cristallin respectif s'interpénètrent. Grâce à cela, il est possible de remplir complètement et plus rapidement le logement 118.

La réunion des différents blocs forme alors la couche 180 qui remplit complètement le logement 118.

Un quatrième procédé de fabrication est illustré à l'aide de la figure 25. La figure 25 et les suivantes sont des coupes verticales, parallèles aux directions X et Z, passant par la partie du guide 6 situé sous la couche en matériau semi-conducteur cristallin fabriquée.

Ce quatrième procédé de fabrication est par exemple identique au premier ou au deuxième procédé de fabrication sauf que :
- le matériau de germination cristalline est du germanium, et
- le matériau semi-conducteur cristallin est aussi du germanium.

Ainsi, selon ce quatrième procédé de fabrication, le plot 60 est remplacé par un plot 200 et la couche 146 est remplacée par une couche 202. Le plot 200 et la couche 202 sont identiques, respectivement, au plot 60 et à la couche 146 sauf qu'ils sont réalisés en germanium cristallin.

Dans ce procédé de fabrication, le paramètre de maille du matériau de germination cristalline n'est pas identique à celui du silicium monocristallin mais seulement similaire à celui du silicium monocristallin. Par conséquent, des défauts apparaissent lors de l'étape de dépôt, par croissance épitaxiale, du germanium à l'intérieur de l'ouverture 130 ou 170. Toutefois, la distance entre les plans Pₛᵤₚ₄ et P_{infSC} est suffisamment grande pour que ces défauts restent piégés à l'intérieur de l'ouverture 130 ou 170 et n'affectent pas la qualité du germe cristallin formé sur le fond 120 du logement 118. Ce phénomène de piégeage est connu sous l'acronyme ART (« *Aspect Ratio Trapping »*)*.* Pour exploiter au mieux le phénomène ART dans le cas où l'ouverture est une tranchée, cette tranchée est disposée par rapport au substrat 4 pour que les défauts se propagent principalement dans le sens de la largeur de la tranchée et non pas dans le sens de sa longueur. Sur la figure 25, la direction de propagation de certains défauts est représentée par des traits 204.

Lorsque le quatrième procédé de fabrication est mis en oeuvre, le guide 14 est remplacé par un guide identique mais réalisé en germanium.

Un cinquième procédé de fabrication est illustré à l'aide de la figure 26. La figure 26 est identique à la figure 25 sauf que la couche 202 est remplacée par une couche 208 en alliage GaAs cristallin.

Le cinquième procédé de fabrication est identique au quatrième procédé de fabrication sauf que, lors de l'épitaxie latérale, le matériau semi-conducteur cristallin qui croît à partir du germe cristallin en germanium formé sur le fond 120 du logement 118 est ici un matériau semi-conducteur cristallin dont les paramètres de maille ne sont pas identiques au paramètre de maille du germe cristallin mais seulement similaires. Ici, le matériau semi-conducteur cristallin est l'alliage GaAs.

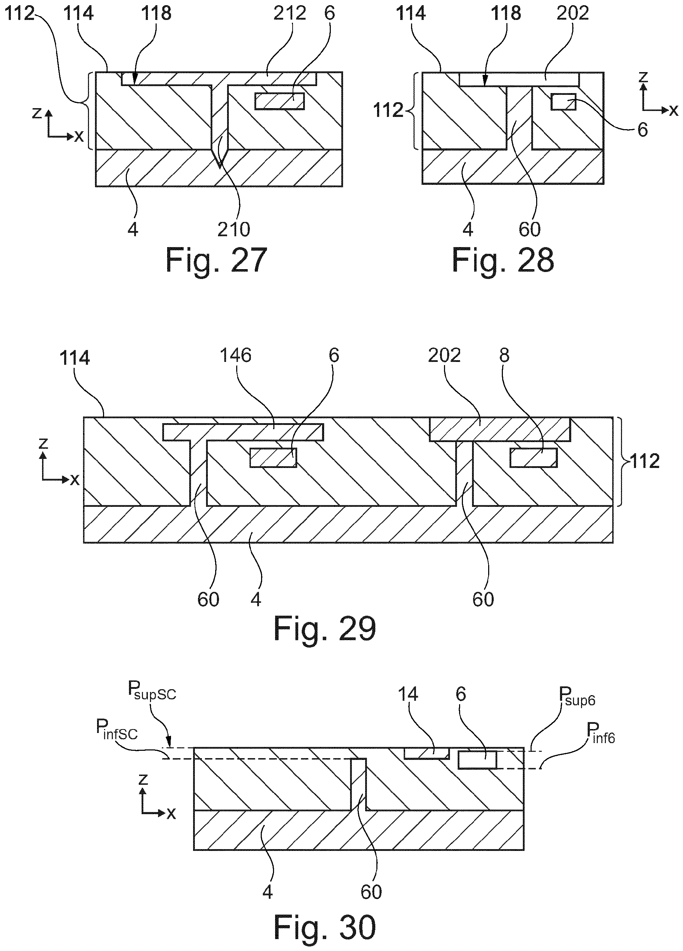

Un sixième procédé de fabrication est illustré à l'aide de la figure 27. La figure 27 est identique à la figure 25 sauf que le plot 200 est remplacé par un plot 210 et la couche 202 est remplacée par une couche 212. Le plot 210 est identique au plot 60 sauf que :
- il est réalisé dans un matériau III-V, par exemple, ici du InP, et
- son extrémité inférieure est en forme de pointe et s'enfonce à l'intérieur du substrat 4.

La couche 212 est identique à la couche 202 sauf qu'elle est réalisée dans le même matériau III-V que celui du plot 210.

Dans ce sixième procédé de fabrication, lors de la formation de l'ouverture qui traverse la couche 112 d'encapsulation, une gravure humide supplémentaire du substrat 4 est réalisée pour faire apparaître la maille (111) du silicium monocristallin du substrat 4. À cause de cette gravure humide supplémentaire, le fond de l'ouverture n'est pas horizontal mais forme une pointe dont les flancs, dans le substrat 4, sont parallèles à la direction de maille (111) du silicium monocristallin du substrat 4. Dans ce sixième procédé de fabrication, le paramètre de maille du matériau de germination cristalline n'est pas similaire au paramètre de maille du silicium monocristallin. Dans ces conditions, pour piéger les défauts à l'intérieur de l'ouverture 130 ou 170, en mettant en oeuvre par le phénomène ART, il faut que les défauts qui apparaissent se propagent dans une direction oblique par rapport à la direction verticale. Ainsi, les défauts qui apparaissent finissent systématiquement par atteindre une paroi verticale de l'ouverture et ne peuvent donc pas se propager jusqu'au germe cristallin formé sur le fond 120 du logement 118. Dès lors, bien que les paramètres de maille du matériau de germination cristalline et du silicium monocristallin ne soient pas similaires, le germe cristallin en matériau III-V formé sur le fond 120 présente très peu de défaut.

Ici, le fait de faire apparaître au fond de l'ouverture 130 ou 170, la maille (111) du silicium monocristallin permet d'obtenir une propagation oblique des défauts par rapport aux parois verticales de l'ouverture et donc de piéger ces défauts en exploitant le phénomène ART. Ensuite, les étapes du sixième procédé de fabrication sont identiques à celles du quatrième procédé de fabrication sauf que le germanium est remplacé par l'alliage InP.

Lorsque le sixième procédé de fabrication est mis en oeuvre, le guide 14 est remplacé par un guide d'onde en matériau III-V.

Un septième procédé de fabrication est illustré à l'aide de la figure 28. La figure 28 est identique à la figure 25 sauf que le plot 200 est remplacé par le plot 60. Ainsi, ce septième procédé de fabrication est identique au premier ou au deuxième procédé de fabrication sauf que le matériau semi-conducteur cristallin est du germanium.

La figure 29 illustre le fait qu'il est possible de mettre en oeuvre, lors de la fabrication d'une même puce photonique, plusieurs des procédés de fabrication précédemment décrits sur le même substrat 4 pour créer des couches à différents endroits en différents matériaux semi-conducteurs cristallins sur la face supérieure 114 de la couche 112 d'encapsulation. Ensuite, des guides d'onde sont réalisés dans chacune de ces couches. Ces guides d'onde sont donc réalisés dans différents matériaux semi-conducteurs cristallins. Par exemple, pour obtenir la structure représentée sur la figure 29, comportant la couche 146 en silicium monocristallin et la couche 202 en germanium, les premier et septième procédés de fabrication sont tous les deux mis en oeuvre lors de la fabrication de cette même puce photonique.

La figure 30 illustre le fait que les différents procédés de fabrication décrits ici peuvent aussi être mis en oeuvre pour fabriquer une puce photonique dans laquelle le guide 6 ne se situe pas au-dessous du guide 14 mais sensiblement au même niveau. Dans ce mode de réalisation, le plan P_{infSC} est situé entre les plans P_{inf6} et Pₛᵤₚ₆ ou confondu avec le plan P_{inf6}. Le plan P_{supSC} est confondu ou situé au-dessus du plan Pₛᵤₚ₆. De préférence, il est situé au-dessus du plan Pₛᵤₚ₆ afin de ne pas amincir le guide 6 lors du polissage de la couche 146 dans laquelle est ensuite réalisé le guide 14 et la partie active du composant 10.

Dans le cas de la figure 30, le guide 6 est optiquement couplé directement au guide 14 par un couplage évanescent latéral.

CHAPITRE III - Variantes

Lors de l'encapsulation du premier guide d'onde, un couche d'arrêt dans un matériau diélectrique différent du matériau 62 est déposée sur la face supérieure du matériau 62. Dans ce cas, la face supérieure 114 de la couche d'encapsulation est formée dans un matériau différent du matériau 62 utilisé pour former la gaine du guide d'onde 6. Par exemple, cette couche d'arrêt est réalisée en HfO₂ ou en SiN.

En variante, le logement creux est omis. Dans ce cas, l'épitaxie latérale fait croître le matériau semi-conducteur cristallin sur la face supérieure 114 sans paroi verticale pour délimiter la zone de dépôt du matériau semi-conducteur cristallin. La largeur de la couche 146 est alors seulement déterminée par la durée de l'opération d'épitaxie latérale.

L'ouverture 130 peut être remplacée par plusieurs tranchées disposées les unes après les autres dans la direction Y.

D'autres formes sont possibles pour la section horizontale de l'ouverture 130 ou 170. Par exemple la section horizontale de l'ouverture est circulaire. Dans ce cas, de multiple ouverture de section transversale circulaire sont réalisées le long des emplacements où doivent être réalisés le guide d'onde 14 et le composant actif 10. La section horizontale de l'ouverture peut aussi être carrée.

Comme précédemment décrit, pour que la formation du germe cristallin sur la face supérieure fonctionne correctement, il n'est pas nécessaire que le matériau de germination cristalline soit du silicium monocristallin. A la place du silicium monocristallin, le matériau de germination cristalline utilisé peut présenter des paramètres de mailles similaires ou différents de ceux du silicium monocristallin. Par exemple, le matériau de germination cristalline peut être du germanium ou un alliage SiGe. Dans ces derniers cas le matériau semi-conducteur cristallin est alors, par exemple, du germanium ou un alliage SiGe.

Pour que l'épitaxie latérale fonctionne correctement, il n'est pas nécessaire que le matériau semi-conducteur cristallin soit identique au matériau de germination cristalline. L'épitaxie latérale fonctionne dès que le matériau semi-conducteur cristallin présente des paramètres de mailles similaires à ceux du matériau de germination cristalline. Par exemple, lorsque le matériau semi-conducteur cristallin du second guide d'onde est du GaAs, le matériau de germination cristalline peut être du germanium.

Lors de la sous-opération 138, au lieu de déposer du silicium amorphe, c'est du silicium polycristallin qui est déposé.

Lors de la sous-opération 144, l'épitaxie en phase solide peut être remplacée par une épitaxie en phase liquide. Dans ce dernier cas, lors du recuit, la température atteinte est supérieure à la température de fusion du matériau semi-conducteur amorphe déposé sur la face supérieure 114.

Lors de la sous-opération 178, le silicium monocristallin peut être déposé en phase vapeur ou en phase liquide.

Lors de l'étape 150, d'autres composants actifs que ceux précédemment décrits peuvent être réalisés. Par exemple, le photodétecteur 12 peut être remplacé par une photodiode à jonction PiN verticale ou latérale ou encore par une photodiode à avalanche ou d'autres types de photodiodes.

D'autres modes de réalisation des composants actifs décrits en référence aux figures sont possibles. Par exemple, en variante, le corps 24 en germanium de la photodiode 10 s'étend au-delà du plan P_{supSC} ou s'arrête avant le plan P_{supSC}.

Le couplage évanescent entre les guides d'ondes 6 et 14 peut aussi être un couplage évanescent indirect. Typiquement, un tel couplage évanescent indirect comporte :
- un premier couplage évanescent directement entre le guide d'onde 6 et un guide d'onde intermédiaire, et
- un second couplage évanescent directement entre le guide d'onde intermédiaire et le guide d'onde 14.
Un tel couplage évanescent indirect est décrit en détail dans la demande US2018231714A1.

### CHAPITRE IV : Avantages des modes de réalisation décrits

Le fait de former un germe cristallin sur la face supérieure 114 de la couche 112 d'encapsulation du guide d'onde en nitrure de silicium puis d'obtenir la couche en matériau semi-conducteur cristallin par épitaxie latérale à partir de ce germe cristallin permet de fabriquer plus simplement une puce photonique comportant à la fois :
- une guide d'onde en nitrure de silicium présentant de très faibles pertes de propagation, et
- des composants actifs.

La gravure du logement creux 118 puis le remplissage de ce logement creux 118 par le matériau semi-conducteur cristallin permet d'utiliser la face supérieure 114 de la couche d'encapsulation située en dehors de ce logement 118 comme couche d'arrêt lors de polissage. Cela permet donc de maîtriser plus précisément l'épaisseur de la couche en matériau semi-conducteur cristallin.

L'épitaxie latérale en phase solide ou liquide par cristallisation du matériau semi-conducteur amorphe permet d'obtenir plus simplement une couche en matériau semi-conducteur cristallin présentant une largeur beaucoup plus grande que son épaisseur.

Le fait que l'ouverture soit une tranchée permet, lors de l'épitaxie latérale, d'avoir un front de croissance plus uniforme de la couche en matériau semi-conducteur cristallin. Cela permet donc de diminuer le nombre de défauts dans cette couche en matériau semi-conducteur cristallin.

Le fait que les guides d'onde 6 et 14 soient situés l'un au-dessus de l'autre et couplé optiquement l'un à l'autre par un couplage évanescent augmente la tolérance vis-à-vis des erreurs de placement de ces guides d'ondes 6 et 14 l'un par rapport à l'autre. Cela simplifie donc la fabrication de la puce électronique.

## Revendications

1. Procédé de fabrication d'une puce photonique comportant un premier guide d'onde en nitrure de silicium stoechiométrique, un second guide d'onde en matériau semi-conducteur cristallin et au moins un composant actif optiquement couplé au premier guide d'onde par l'intermédiaire du second guide d'onde, ce procédé comportant :
- la fourniture (100) d'un substrat en silicium monocristallin sur lequel est déposé une couche en matériau diélectrique, ce substrat s'étendant principalement dans un plan appelé "plan du substrat", puis
- le dépôt (104) en phase vapeur, sur la couche en matériau diélectrique, d'une couche de nitrure de silicium stoechiométrique suivi d'un recuit (106) à une température comprise entre 1000°C et 1400°C, puis
- la réalisation (108) du premier guide d'onde dans cette couche de nitrure de silicium stoechiométrique déposée et recuite, puis
- l'encapsulation (110) du premier guide d'onde dans un matériau diélectrique pour obtenir une couche d'encapsulation dans laquelle le premier guide d'onde est encapsulé, cette couche d'encapsulation présentant une face supérieure du côté opposé au substrat, puis
- la création (126; 166) d'une couche en matériau semi-conducteur cristallin directement sur la face supérieure de la couche d'encapsulation, puis
- la réalisation (150) du second guide d'onde dans cette couche en matériau semi-conducteur cristallin, ce second guide d'onde étant optiquement couplé au premier guide d'onde par un couplage évanescent, puis
- la réalisation (150) du composant optique actif, ce composant optique actif étant raccordé optiquement au premier guide d'onde par l'intermédiaire du second guide d'onde, puis
- la réalisation (154) de prises électriques pour raccorder électriquement le composant optique actif à une source d'énergie électrique,
**caractérisé en ce que** la création (126; 166) de la couche en matériau semi-conducteur cristallin comporte les opérations suivantes :
a) la formation (128; 168) d'une ouverture qui traverse la couche d'encapsulation et débouche dans ou sur le substrat, puis
b) le dépôt (132; 172) par croissance épitaxiale d'un matériau de germination cristalline à l'intérieur de l'ouverture jusqu'à ce que ce matériau de germination cristalline atteigne la face supérieure et forme un germe cristallin sur cette face supérieure, ce matériau de germination cristalline ayant des paramètres de maille identiques, à plus ou moins 5% près, à ceux du matériau semi-conducteur cristallin, puis
c) une épitaxie latérale (136; 176), du même matériau semi-conducteur cristallin que celui dans lequel est réalisé le second guide d'onde, à partir du germe cristallin formé pour former la couche en matériau semi-conducteur cristallin dans laquelle le second guide d'onde est ensuite réalisé.

2. Procédé selon la revendication 1, dans lequel, avant la création de la couche en matériau semi-conducteur cristallin, le procédé comporte, la structuration (116) de la face supérieure pour former, dans cette face supérieure, un logement creux présentant un fond parallèle au plan du substrat et des parois perpendiculaires au fond, puis lors de la création (126; 166) de la couche en matériau semi-conducteur cristallin :
- l'ouverture est formée dans le fond du logement creux, puis
- l'épitaxie latérale (136; 176) remplit complètement ce logement creux.

3. Procédé selon l'une quelconque des revendications précédentes, dans lequel l'épitaxie latérale comporte :
- le dépôt (138) d'une couche en matériau semi-conducteur amorphe sur le germe cristallin formé sur la face supérieure, puis
- un recuit (144) à une température apte à provoquer la cristallisation du matériau semi-conducteur amorphe à partir du germe cristallin.

4. Procédé selon la revendication 1 ou 2, dans lequel l'épitaxie latérale consiste à déposer (178) directement le matériau semi-conducteur cristallin sur la face supérieure par croissance épitaxiale à partir du germe cristallin formé sur cette face supérieure.

5. Procédé selon la revendication 3 ou 4, dans lequel l'ouverture est une tranchée dont la longueur est deux fois grande que sa largeur.

6. Procédé selon l'une quelconque des revendications précédentes, dans lequel :
- lors de la réalisation (108) du premier guide d'onde, ce premier guide d'onde est réalisé entre un premier plan inférieur et un premier plan supérieur, ces premiers plans étant parallèles au plan du substrat,
- lors de la réalisation (150) du second guide d'onde, ce second guide d'onde est réalisé entre un second plan inférieur et un second plan supérieur, ces seconds plans étant parallèles au plan du substrat et tous les deux situés au-dessus des premiers plans dans une direction perpendiculaire au plan du substrat.

7. Procédé selon l'une quelconque des revendications précédentes, dans lequel le matériau de germination cristalline est du silicium monocristallin.

8. Procédé selon l'une quelconque des revendications précédentes, dans lequel le matériau semi-conducteur cristallin est choisi dans le groupe constitué :
- du silicium,
- du germanium,
- de l'alliage SiGe, et
- d'un matériau III-V.

9. Procédé selon la revendication 8, dans lequel le procédé comporte :
- l'exécution des opérations a) à c) pour créer une première couche en matériau semi-conducteur cristallin, et
- l'exécution des opérations a) à c) pour créer une seconde couche en matériau semi-conducteur cristallin, cette seconde couche en matériau semi-conducteur cristallin étant réalisée dans un matériau semi-conducteur cristallin différent de celui de la première couche, puis
- la réalisation du second guide d'onde dans la première couche en matériau semi-conducteur cristallin et la réalisation d'un troisième guide d'onde dans la seconde couche en matériau semi-conducteur.

10. Procédé selon l'une quelconque des revendications précédentes, dans lequel :
- le matériau de germination cristalline déposé à l'intérieur de l'ouverture par croissance épitaxiale est différent du silicium cristallin, et
- la largeur de l'ouverture est adaptée pour piéger, à l'intérieur de cette ouverture, la majorité des défauts du matériau de germination cristalline ainsi déposé par croissance épitaxiale.

11. Procédé selon l'une quelconque des revendications précédentes, dans lequel le dépôt (104) en phase vapeur de la couche de nitrure de silicium stoechiométrique est réalisé sous une pression inférieure à 39996 mPa (300 mTorr).

12. Puce photonique obtenue par un procédé de fabrication conforme à l'une quelconque des revendications précédentes, cette puce photonique comportant :
- un substrat (4) en silicium monocristallin s'étendant principalement dans un plan appelé "plan du substrat",
- un premier guide d'onde (6, 8) en nitrure de silicium stoechiométrique présentant des pertes de propagation inférieure à 4 dB/m pour les longueurs d'onde comprises entre 1530 nm et 1565 nm, le coeur de ce premier guide d'onde s'étendant, dans une direction perpendiculaire au plan du substrat, depuis un premier plan inférieur (P_{inf6}) jusqu'à un premier plan supérieur (Pₛᵤₚ₆), ces premiers plans étant parallèles au plan du substrat et le premier plan inférieur étant le plan le plus proche du substrat,
- un second guide d'onde (14, 16) en matériau semi-conducteur cristallin optiquement couplé au premier guide d'onde par un couplage évanescent, le coeur de ce second guide d'onde s'étendant, dans la direction perpendiculaire au plan du substrat, depuis un second plan inférieur (P_{infSC}) jusqu'à un second plan supérieur (P_{supSC}), ces seconds plans étant parallèles au plan du substrat et le second plan inférieur (P_{infSC}) étant le plan le plus proche du substrat, et
- au moins un composant actif (10, 12) optiquement couplé au premier guide d'onde (6, 8) par l'intermédiaire du second guide d'onde (14, 16), ce composant actif comportant des prises électriques (30, 32) apte à le raccorder électriquement à une source d'énergie électrique,
**caractérisé en ce que** la puce photonique comporte un plot (60; 204; 210) qui s'étend depuis le substrat en silicium monocristallin jusqu'au second plan inférieur (P_{infSC}), ce plot (60; 204; 210) étant réalisé dans un matériau de germination cristalline qui forme un germe cristallin sur le second plan inférieur (P_{infSC}), ce matériau de germination cristalline ayant des paramètres de maille identiques, à plus ou moins 5% près, à ceux du matériau semi-conducteur cristallin du second guide d'onde (14, 16).

13. Puce photonique selon la revendication 12, dans laquelle le second plan inférieur (P_{infSC}) est situé au-dessus du premier plan supérieur (Pₛᵤₚ₆).

14. Puce photonique selon l'une quelconque des revendications 12 à 13, dans laquelle la hauteur du plot en matériau de germination cristalline est supérieure à 4 µm.

## Patentansprüche

1. Verfahren zur Herstellung eines photonischen Chips, der einen ersten Wellenleiter aus stöchiometrischem Siliciumnitrid, einen zweiten Wellenleiter aus kristallinem Halbleitermaterial und mindestens ein aktives Bauelement aufweist, das mittels des zweiten Wellenleiters optisch mit dem ersten Wellenleiter gekoppelt ist, wobei dieses Verfahren aufweist:
- die Bereitstellung (100) eines Substrats aus monokristallinem Silicium, auf das eine Schicht aus dielektrischem Material abgeschieden wird, wobei dieses Substrat sich hauptsächlich in einer "Ebene des Substrats" genannten Ebene erstreckt, dann
- die chemische Dampfabscheidung (104) auf die Schicht aus dielektrischem Material einer Schicht aus stöchiometrischem Siliciumnitrid gefolgt von einem Glühen (106) bei einer Temperatur zwischen 1000°C und 1400°C, dann
- die Herstellung (108) des ersten Wellenleiters in dieser abgeschiedenen und geglühten Schicht aus stöchiometrischem Siliciumnitrid, dann
- die Einkapselung (110) des ersten Wellenleiters in einem dielektrischen Material, um eine Einkapselungsschicht zu erhalten, in der der erste Wellenleiter eingekapselt ist, wobei diese Einkapselungsschicht eine Oberseite auf der dem Substrat gegenüberliegenden Seite aufweist, dann
- die Erzeugung (126; 166) einer Schicht aus kristallinem Halbleitermaterial direkt auf der Oberseite der Einkapselungsschicht, dann
- die Herstellung (150) des zweiten Wellenleiters in dieser Schicht aus kristallinem Halbleitermaterial, wobei dieser zweite Wellenleiter durch eine evaneszente Kopplung optisch mit dem ersten Wellenleiter gekoppelt ist, dann
- die Herstellung (150) des aktiven optischen Bauelements, wobei dieses aktive optische Bauelement mittels des zweiten Wellenleiters optisch an den ersten Wellenleiter angeschlossen ist, dann
- die Herstellung (154) von Stromanschlüssen, um das aktive optische Bauelement elektrisch an eine Quelle elektrischer Energie anzuschließen,
**dadurch gekennzeichnet, dass** die Erzeugung (126; 166) der Schicht aus kristallinem Halbleitermaterial die folgenden Arbeitsgänge aufweist:
a) das Formen (128; 168) einer Öffnung, die die Einkapselungsschicht durchquert und in oder auf dem Substrat mündet, dann
b) das Abscheiden (132; 172) durch epitaxiales Wachstum eines Kristallkeimbildungsmaterials innerhalb der Öffnung, bis dieses Kristallkeimbildungsmaterial die Oberseite erreicht und auf dieser Oberseite einen Kristallkeim bildet, wobei dieses Kristallkeimbildungsmaterial bis auf mehr oder weniger 5% gleiche Gitterparameter wie diejenigen des kristallinen Halbleitermaterials hat, dann
c) eine laterale Epitaxie (136; 176), des gleichen kristallinen Halbleitermaterials wie dasjenige, aus dem der zweite Wellenleiter hergestellt ist, ausgehend von dem geformten Kristallkeim, um die Schicht aus kristallinem Halbleitermaterial zu formen, in der der zweite Wellenleiter anschließend hergestellt wird.

2. Verfahren nach Anspruch 1, wobei das Verfahren vor der Erzeugung der Schicht aus kristallinem Halbleitermaterial die Strukturierung (116) der Oberseite aufweist, um in dieser Oberseite eine hohle Aufnahme zu formen, die einen Boden parallel zur Ebene des Substrats und Wände lotrecht zum Boden aufweist, dann bei der Erzeugung (126; 166) der Schicht aus kristallinem Halbleitermaterial:
- die Öffnung im Boden der hohlen Aufnahme geformt wird, dann
- die laterale Epitaxie (136; 176) diese hohle Aufnahme vollständig füllt.

3. Verfahren nach einem der vorhergehenden Ansprüche, wobei die laterale Epitaxie aufweist:
- das Abscheiden (138) einer Schicht aus amorphem Halbleitermaterial auf den an der Oberseite geformten Kristallkeim, dann
- ein Glühen (144) bei einer Temperatur, die fähig ist, die Kristallisierung des amorphen Halbleitermaterials ausgehend vom Kristallkeim hervorzurufen.

4. Verfahren nach Anspruch 1 oder 2, wobei die laterale Epitaxie darin besteht,. das kristalline Halbleitermaterial auf die Oberseite durch epitaxiales Wachstum ausgehend vom auf dieser Oberseite geformten Kristallkeim direkt abzuscheiden (178).

5. Verfahren nach Anspruch 3 oder 4, wobei die die Öffnung ein Graben ist, dessen Länge doppelt so groß ist wie seine Breite.

6. Verfahren nach einem der vorhergehenden Ansprüche, wobei:
- bei der Herstellung (108) des ersten Wellenleiters dieser erste Wellenleiter zwischen einer ersten unteren Ebene und einer ersten oberen Ebene hergestellt wird, wobei diese ersten Ebenen parallel zur Ebene des Substrats sind,
- bei der Herstellung (150) des zweiten Wellenleiters dieser zweite Wellenleiter zwischen einer zweiten unteren Ebene und einer zweiten oberen Ebene hergestellt wird, wobei diese zweiten Ebenen parallel zur Ebene des Substrats sind und sich beide über den ersten Ebenen in einer Richtung lotrecht zur Ebene des Substrats befinden.

7. Verfahren nach einem der vorhergehenden Ansprüche, wobei das Kristallkeimbildungsmaterial monokristallines Silicium ist.

8. Verfahren nach einem der vorhergehenden Ansprüche, wobei das kristalline Halbleitermaterial aus der Gruppe ausgewählt wird, die besteht aus:
- Silicium,
- Germanium,
- der SiGe-Legierung, und
- einem III-V-Material.

9. Verfahren nach Anspruch 8, wobei das Verfahren aufweist:
- die Ausführung der Arbeitsgänge a) bis c), um eine erste Schicht aus kristallinem Halbleitermaterial zu erzeugen, und
- die Ausführung der Arbeitsgänge a) bis c), um eine zweite Schicht aus kristallinem Halbleitermaterial zu erzeugen, wobei diese zweite Schicht aus kristallinem Halbleitermaterial aus einem kristallinen Halbleitermaterial anders als dasjenige der ersten Schicht hergestellt wird, dann
- die Herstellung des zweiten Wellenleiters in der ersten Schicht aus kristallinem Halbleitermaterial und die Herstellung eines dritten Wellenleiters in der zweiten Schicht aus Halbleitermaterial.

10. Verfahren nach einem der vorhergehenden Ansprüche, wobei:
- das innerhalb der Öffnung durch epitaxiales Wachstum abgeschiedene Kristallkeimbildungsmaterial sich vom kristallinen Silicium unterscheidet, und
- die Breite der Öffnung geeignet ist, um im Inneren dieser Öffnung den größten Teil der Fehler des so durch epitaxiales Wachstum abgeschiedenen Kristallkeimbildungsmaterials einzuschließen.

11. Verfahren nach einem der vorhergehenden Ansprüche, wobei die Dampfabscheidung (104) der Schicht aus stöchiometrischem Siliciumnitrid unter einem Druck von weniger als 39996 mPa (300 mTorr) durchgeführt wird.

12. Photonischer Chip, erhalten durch ein Herstellungsverfahren nach einem der vorhergehenden Ansprüche, wobei dieser photonische Chip aufweist:
- ein Substrat (4) aus monokristallinem Silicium, das sich hauptsächlich in einer "Ebene des Substrats" genannten Ebene erstreckt,
- einen ersten Wellenleiter (6, 8) aus stöchiometrischem Siliciumnitrid, der Ausbreitungsverluste geringer als 4 dB/m für die Wellenlängen zwischen 1530 nm und 1565 nm aufweist, wobei der Kern dieses ersten Wellenleiters sich in einer Richtung lotrecht zur Ebene des Substrats von einer ersten unteren Ebene (P_{inf6}) bis zu einer ersten oberen Ebene (Pₛᵤₚ₆) erstreckt, wobei diese ersten Ebenen parallel zur Ebene des Substrats sind und die erste untere Ebene die dem Substrat am nächsten liegende Ebene ist,
- einen zweiten Wellenleiter (14, 16) aus kristallinem Halbleitermaterial, der durch eine evaneszente Kopplung optisch mit dem ersten Wellenleiter gekoppelt ist, wobei der Kern dieses zweiten Wellenleiters sich in der Richtung lotrecht zur Ebene des Substrats von einer zweiten unteren Ebene (P_{infSC}) bis zu einer zweiten oberen Ebene (P_{supSC}) erstreckt, wobei diese zweiten Ebenen parallel zur Ebene des Substrats sind und die zweite untere Ebene (P_{infSC}) die dem Substrat am nächsten liegende Ebene ist, und
- mindestens ein aktives Bauelement (10, 12), das mittels des zweiten Wellenleiters (14, 16) optisch mit dem ersten Wellenleiter (6, 8) gekoppelt ist, wobei dieses aktive Bauelement Stromanschlüsse (30, 32) trägt, die fähig sind, es elektrisch an eine Quelle elektrischer Energie anzuschließen,
**dadurch gekennzeichnet, dass** der photonische Chip einen Block (60; 204; 210) aufweist, der sich vom Substrat aus monokristallinem Silicium bis zur zweiten unteren Ebene (P_{infSC}) erstreckt, wobei dieser Block (60; 204; 210) aus einem Kristallkeimbildungsmaterial hergestellt ist, das einen Kristallkeim auf der zweiten unteren Ebene (P_{infSC}) formt, wobei dieses Kristallkeimbildungsmaterial bis auf mehr oder weniger 5% gleiche Gitterparameter wie diejenigen des kristallinen Halbleitermaterials des zweiten Wellenleiters (14, 16) hat.

13. Photonischer Chip nach Anspruch 12, wobei die zweite untere Ebene (P_{infSC}) sich über der ersten oberen Ebene (Pₛᵤₚ₆) befindet.

14. Photonischer Chip nach einem der Ansprüche 12 bis 13, wobei die Höhe des Blocks aus Kristallkeimbildungsmaterial größer ist als 4 µm.

## Claims

1. Method for manufacturing a photonic chip comprising a first waveguide made of stoichiometric silicon nitride, a second waveguide made of crystalline semiconductor material and at least one active component which is optically coupled to the first waveguide via the second waveguide, this method comprising:
- providing (100) a substrate made of monocrystalline silicon on which a layer made of dielectric material is deposited, this substrate extending mainly in a plane called "plane of the substrate", then
- vapour-phase depositing (104), on the layer made of dielectric material, a layer of stoichiometric silicon nitride followed by annealing (106) at a temperature of between 1000°C and 1400°C, then
- producing (108) the first waveguide from this deposited and annealed layer of stoichiometric silicon nitride, then
- encapsulating (110) the first waveguide in a dielectric material in order to obtain an encapsulating layer in which the first waveguide is encapsulated, this encapsulating layer having an upper face on the side opposite the substrate, then
- creating (126; 166) a layer made of crystalline semiconductor material directly on the upper face of the encapsulating layer, then
- producing (150) the second waveguide from this layer made of crystalline semiconductor material, this second waveguide being optically coupled to the waveguide by evanescent coupling, then
- producing (150) the active optical component, this active optical component being optically connected to the first waveguide via the second waveguide, then
- producing (154) power outlets in order to electrically connect the active optical component to a source of electrical energy,
**characterized in that** creating (126; 166) the layer made of crystalline semiconductor material comprises the following operations:
a) forming (128; 168) an aperture which passes through the encapsulating layer and opens into or onto the substrate, then
b) epitaxially depositing (132; 172) a crystal nucleation material inside the aperture until this crystal nucleation material reaches the upper face and forms a seed crystal on this upper face, this crystal nucleation material having lattice parameters which are identical, to within plus or minus 50%, to those of the crystalline semiconductor material, then
c) laterally epitaxially growing (136; 176) the same crystalline semiconductor material as that from which the second waveguide is produced from the seed crystal formed in order to form the layer made of crystalline semiconductor material from which the second waveguide is then produced.

2. Method according to Claim 1, wherein, before the layer made of crystalline semiconductor material is created, the method comprises structuring (116) the upper face in order to form, in this upper face, a hollow recess having a bottom parallel to the plane of the substrate and walls perpendicular to the bottom, then, when the layer made of crystalline semiconductor material is created (126; 166):
- the aperture is formed in the bottom of the hollow recess, then
- the lateral epitaxial growth (136; 176) completely fills this hollow recess.

3. Method according to either one of the preceding claims, wherein the lateral epitaxial growth comprises:
- depositing (138) a layer made of amorphous semiconductor material on the seed crystal formed on the upper face, then
- annealing (144) at a temperature able to cause the crystallization of the amorphous semiconductor material from the seed crystal.

4. Method according to Claim 1 or 2, wherein the lateral epitaxial growth consists in directly depositing (178) the crystalline semiconductor material on the upper face by epitaxial growth from the seed crystal formed on this upper face.

5. Method according to Claim 3 or 4, wherein the aperture is a slit, the length of which is twice as large as its width.

6. Method according to any one of the preceding claims, wherein:
- when the first waveguide is produced (108), this first waveguide is produced between a first lower plane and a first upper plane, these first planes being parallel to the plane of the substrate,
- when the second waveguide is produced (150), this second waveguide is produced between a second lower plane and a second upper plane, these second planes being parallel to the plane of the substrate and both located above the first planes in a direction perpendicular to the plane of the substrate.

7. Method according to any one of the preceding claims, wherein the crystal nucleation material is monocrystalline silicon.

8. Method according to any one of the preceding claims, wherein the crystalline semiconductor material is chosen from the group consisting of:
- silicon,
- germanium,
- the alloy SiGe, and
- a III-V material.

9. Method according to Claim 8, wherein the method comprises:
- executing operations a) to c) in order to create a first layer made of crystalline semiconductor material, and
- executing operations a) to c) in order to create a second layer made of crystalline semiconductor material, this second layer made of crystalline semiconductor material being produced from a crystalline semiconductor material different from that of the first layer, then
- producing the second waveguide from the first layer made of crystalline semiconductor material and producing a third waveguide from the second layer made of semiconductor material.

10. Method according to any one of the preceding claims, wherein:
- the crystal nucleation material deposited inside the aperture by epitaxial growth is different from crystalline silicon, and
- the width of the aperture is adapted to trap, inside this aperture, the majority of the defects of the crystal nucleation material thus deposited by epitaxial growth.

11. Method according to any one of the preceding claims, wherein the layer of stoichiometric silicon nitride is vapour-phase deposited (104) under a pressure of less than 39,996 mPa (300 mTorr).

12. Photonic chip obtained by a manufacturing method according to any one of the preceding claims, this photonic chip comprising:
- a substrate (4) made of monocrystalline silicon extending mainly in a plane called "plane of the substrate",
- a first waveguide (6, 8) made of stoichiometric silicon nitride having propagation losses of less than 4 dB/m for wavelengths of between 1530 nm and 1565 nm, the core of this first waveguide extending, in a direction perpendicular to the plane of the substrate, from a first lower plane (P_{inf6}) as far as a first upper plane (Pₛᵤₚ₆), these first planes being parallel to the plane of the substrate and the first lower plane being the plane closest to the substrate,
- a second waveguide (14, 16) made of crystalline semiconductor material optically coupled to the first waveguide by evanescent coupling, the core of this second waveguide extending, in the direction perpendicular to the plane of the substrate, from a second lower plane (P_{infSC}) as far as a second upper plane (P_{supSC}), these second planes being parallel to the plane of the substrate and the second lower plane (P_{infSC}) being the plane closest to the substrate, and
- at least one active component (10, 12) optically coupled to the first waveguide (6, 8) via the second waveguide (14, 16), this active component comprising power outlets (30, 32) able to electrically connect it to a source of electrical energy,
**characterized in that** the photonic chip comprises a stud (60; 204; 210) which extends from the substrate made of monocrystalline silicon as far as the second lower plane (P_{infSC}), this stud (60; 204; 210) being produced from a crystal nucleation material which forms a seed crystal on the second lower plane (P_{infSC}), this crystal nucleation material having lattice parameters which are identical, to within plus or minus 5%, to those of the crystalline semiconductor material of the second waveguide (14, 16).

13. Photonic chip according to Claim 12, wherein the second lower plane (P_{infSC}) is located above the first upper plane (Pₛᵤₚ₆).

14. Photonic chip according to either one of Claims 12 and 13, wherein the height of the stud made of crystal nucleation material is greater than 4 µm.
